# EUROPEAN PATENT APPLICATION

(11) **EP 1 727 294 A1**
(43) Date of publication of application: **29.11.2006**
(21) Application number: 06002657.2
(22) Date of filing: 09.02.2006
(51) Int. Cl.: H04B 3/10

(54) **Transmitter and receiver with transversal filter**

(30) Priority: 26.05.2005 JP 2005154084
(71) Applicant: HITACHI, LTD., Chiyoda-ku Tokyo 100-8280 (JP)
(72) Inventor: Toyoda, Hidehiro Hitachi, Ltd. Intel. Prop. Office, Chiyoda-ku Tokyo 100-8220 (JP)
(74) Representative: Strehl Schübel-Hopf & Partner

(57) **Abstract**

Provided is a transversal filter, in which delayers and multipliers are connected in series, includes: a first multiplier for multiplying a first tap coefficient set by a tap coefficient register module and an input signal to output a result of multiplication; a first delayer for delaying the value output from the first multiplier by a predetermined time to output the delayed value; a second multiplier for multiplying a second tap coefficient set by the tap coefficient register module and an input signal to output a result of multiplication; a first adder for adding the value output from the delayer situated upstream to the value output from the second multiplier to output a result of addition; a second delayer for delaying the value output from the first adder by a predetermined time to output the delayed value; and a selector for selecting one of the input signal, the value output from the first delayer, and the value output from the second delayer to output the selected one.

## Description

### CLAIM OF PRIORITY

The present application claims priority from Japanese application P2005-154084 filed on May 26, 2005, the content of which is hereby incorporated by reference into this application.

### BACKGROUND

This invention relates to a transversal filter for improving characteristic degradation in a communication channel, and more particularly to a transversal filter capable of creating a signal in conformity with a characteristic of the communication channel and of minimizing a processing time.

For transmitting a signal between two devices, a communication channel such as a telecommunication channel using a conductor or an optical communication channel such as an optical fiber is used. The communication channel generally has a specific bandwidth W (Hz). When a signal is transmitted through the communication channel, the transmitted signal is limited to the bandwidth W of the communication channel to be attenuated. Therefore, the communication channel is modeled as a linear filter having such an equivalent low pass characteristic that attenuation becomes zero in the frequency range represented by: |f| > W (f is a frequency).

The communication channel having a limited bandwidth as described above is referred to as a "limited bandwidth channel". A frequency response characteristic of the limited bandwidth channel is denoted as *C(f)*.

As described above, the communication channel is a low pass filter with attenuation being zero in the range represented by: |f| > W. When a signal is transmitted through the communication channel at a symbol rate of W or larger, symbols, which are adjacent in terms of time and frequency, affect each other to prevent the signal from being correctly transmitted. This phenomenon is called inter-symbol interference (ISI).

In order to solve the problem of the ISI, there is a method of enhancing a signal to be transmitted in conformity with the frequency response characteristic *C(f)* before transmission. There is also a method of compensating for or reducing the ISI for the transmitted signal on the receiver side.

As a device of enhancing a signal or compensating for the ISI as described above, an equalizer or a filter is known. As one of the equalizers, a transversal film is known.

A theoretical transversal filter includes delayers, multipliers, and an integrator. The delayer delays an input signal by one symbol time (corresponding to a minimum time unit; one symbol represents one bit or multiple bits) so as to output the delayed signal. All the delayers are connected in succession. A tap coefficient is input to the multiplier. The multiplier multiplies two input values so as to output the result of multiplication. Outputs from all the multipliers are input to the integrator, which then outputs the sum of all the inputs, as described in "Digital Communications" by J. G. Proakis, translated in Japanese by Kouichi Sakaniwa, Hiroshi Suzuki et al., Science Press, Inc., 1999, page 697.

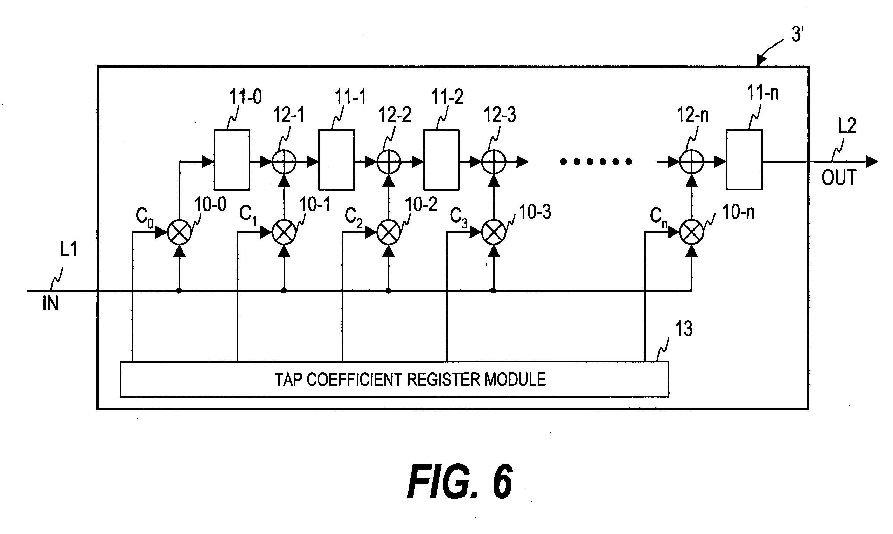

FIG. 6 is a block diagram showing an example of a conventional transversal filter.

A filter 3' is an example of a transversal filter including a plurality of adders.

The filter 3' includes multipliers 10 (10-0 through 10-*n*), delayers 11 (11-0 through 11-*n*), adders 12 (12-1 through 12-*n*) and a tap coefficient register module 13. The filter 3' outputs a signal, which is input to an input terminal L1, from an output terminal L2.

Each of the multipliers 10 (10-0 through 10-*n*) multiplies two input values so as to output the result of multiplication. Each of tap coefficients C (*C0* through *Cn*) set by the tap coefficient register module 13 is input to one of the inputs of the multiplier 10, whereas the signal input to the input terminal L1 is input to the other input.

Among all the multipliers 10, an output of the first multiplier 10-0 is connected to an input of the delayer 11-0. An output of each of the multipliers 10-1 through 10-*n* is connected to one of the outputs of each of the adders 12-1 through 12-*n*.

Each of the adders 12 (12-1 through 12-*n*) adds two input values so as to output the result of addition. An output of each of the delayers 11-0 through 11-(*n*-1) is input to one of the inputs of each of the adders 12-1 through 12-*n*, whereas an output of each of the multipliers 10-1 through 10-*n* is input to the other input of each of the adders 12-1 through 12-*n*. The outputs of the adders 12-1 through 12-*n* are connected to the inputs of the delayers 11-1 through 11-*n*, respectively. An output of the delayer 11-*n* is output from the output terminal L2.

The filter 3' is realized by dividing the integrator in the above-described conventional transversal filter into a plurality of adders. With this structure, since the plurality of adders perform processing in a pipelined manner, the filter 3' can operate at a high speed.

As an example of application of the transversal filter, the following magnetic disk device as described in JP 3513228 B is known. Prior to the start of use of the device, an isolated waveform writing part designates a head number and a track number to write a prescribed isolated waveform in a predetermined area for each track of a disk medium. Next, the isolated waveform is read out by an isolated waveform reading part and then is quantized in an analog/digital converter. A tap coefficient calculating part calculates a tap coefficient of the transversal filter. The tap coefficient calculated in the tap coefficient calculating part is stored in a memory based on the track number and the head number used for writing the isolated waveform. At the time of reproduction during the use of the device, a tap coefficient setting part reads out the corresponding tap coefficient from the memory based on the track number and the head number designated by a seek command and sets the read tap coefficient in the transversal filter.

In the invention described in JP 3513228 B, by designating 0 as a coefficient of an unused tap, an arbitrary number of taps are selected to determine a characteristic of the filter. As a result, a minimum number of required taps suitable for the communication channel is selected, saving the effort of calculating an optimal value for the tap coefficient.

### SUMMARY

As described above, the conventional transversal filter increases the number of pairs of the delayer and the integrator (the number of taps) to enhance the quality of a signal to be transmitted in such a manner that the signal quality becomes more suitable for the characteristic of the transmission channel. However, the conventional transversal filter does not take a processing time of the multipliers and the integrators into consideration. More specifically, in order to continuously operate the theoretical transversal filter, the processing of the multipliers and the integrators is required to be terminated within one symbol time. When a signal is transmitted at a high speed, one symbol time becomes extremely short, making it difficult to realize the termination of the processing within such a short period of time.

For example, in the conventional transversal filter shown in FIG. 6, the number of delayers 11 are required to be prepared in conformity with the highest required quality for transmission of a signal. Therefore, in a communication channel with little quality degradation, there arises a problem in that a delay time becomes disadvantageously longer than needed due to the processing of the delayers 11 although a small number of taps are required.

Moreover, in the invention described in JP 3513228 B, the number of taps is reduced to reduce a time for calculating an optical value for the tap coefficient. More specifically, 0 is input as an unused tap coefficient so as to virtually invalidate the unused tap. However, even through 0 is input as the tap coefficient, a calculation processing of the tap coefficient occurs in the tap calculation processing. Therefore, a time required for the calculation processing remains constant regardless of the number of taps. Accordingly, the delay time of the processing is not reduced.

It is therefore an object of this invention to provide a transversal filter suitable for increasing the speed of signal transmission by increasing or reducing the number of taps of the filter in conformity with a loss in a communication channel to reduce and minimize a processing delay time for a calculation processing.

According to this invention, there is provided a transversal filter, in which delayers and multipliers are connected in series, including: a first multiplier for multiplying a first tap coefficient set by a tap coefficient register module and an input signal to output a result of multiplication; a first delayer for delaying the value output from the first multiplier by a predetermined time to output the delayed value; a second multiplier for multiplying a second tap coefficient set by the tap coefficient register module and an input signal to output a result of multiplication; a first adder for adding the value output from the delayer situated upstream to the value output from the second multiplier to output a result of addition; a second delayer for delaying the value output from the first adder by a predetermined time to output the delayed value; and a selector for selecting one of the input signal, the value output from the first delayer and the value output from the second delayer to output the selected one.

According to an embodiment of this invention, a transversal filter capable of operating at a high speed can be realized, while a processing delay time can be minimized because a minimum number of required taps is selected in conformity with the characteristic of a transmission channel.

### BRIEF DESCRIPTION OF THE DRAWINGS

FIG. 1 is an explanatory diagram of a signal transmission system using a transversal filter according to an embodiment of this invention.
FIG. 2 is a block diagram showing an example of the transversal filter according to the embodiment of this invention.
FIG. 3 is a flowchart of control of the number of taps by a selector controller according to the embodiment of this invention.
FIG. 4 is an explanatory diagram of another example of the signal transmission system using a transversal filter according to the embodiment of this invention.
FIG. 5 is an explanatory diagram of further another example of the signal transmission system using transversal filters according to the embodiment of this invention.
FIG. 6 is a block diagram showing an example of a conventional transversal filter.

### DETAILED DESCRIPTION OF THE PREFERRED EMBODIMENT

Hereinafter, an embodiment of this invention will be described with reference to the accompanying drawings.

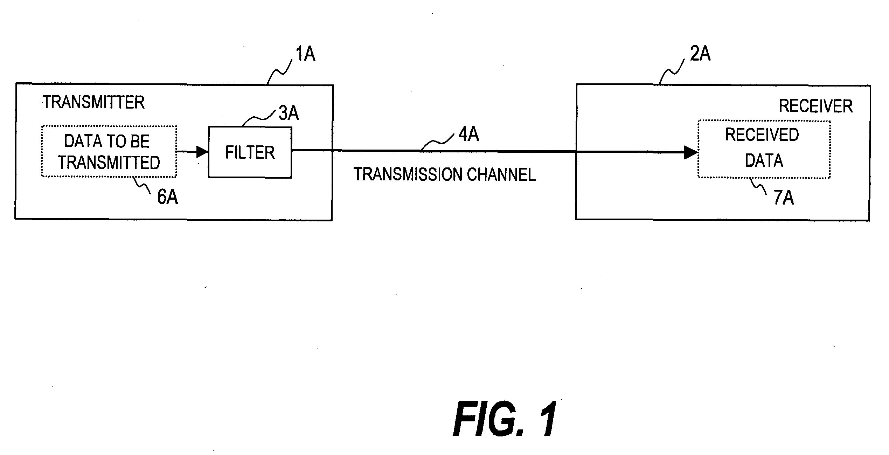

FIG. 1 is an explanatory diagram of a signal transmission system using a transversal filter according to this invention.

A transmitter 1A and a receiver 2A are connected to each other through a transmission channel 4A. The transmitter 1A transmits transmitted data 6A to the receiver 2A through the transmission channel 4A. The receiver 2A receives the transmitted data 6A as received data 7A.

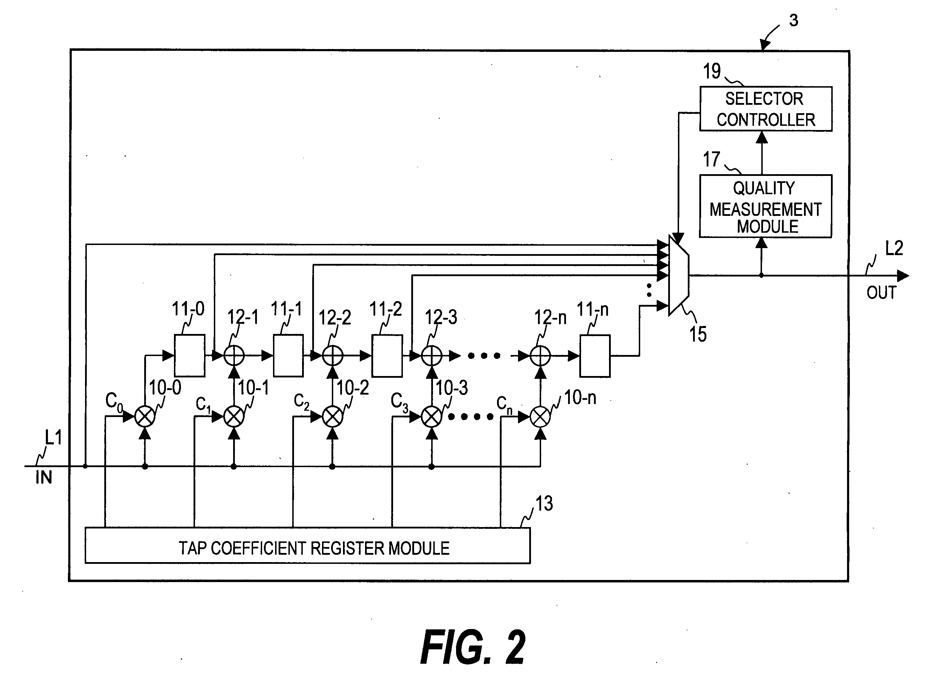

The transmitter 1A includes a filter 3A. The filter 3A is composed of a transversal filter described below with reference to FIG. 2.

After enhancing the transmitted data 6A so as to obtain an optimal signal at a frequency response characteristic *C(f)* of the transmission channel 4A and at the time when the receiver 2A receives the signal, the filter 3A transmits the obtained signal through the transmission channel.

The transmitter 1A and the receiver 2A are used for, for example, a network interface provided in a computer, a storage system, a router, a switch, or the like. As the transmission channel 4A, a communication channel such as the Ethernet, the Fibre Channel, or an optical fiber is used.

FIG. 2 is a block diagram showing an example of a transversal filter according to an embodiment of this invention.

The filter 3 is a transversal filter including an input terminal L1, an output terminal L2, multipliers 10 (10-0 through 10-*n*), delayers 11 (11-0 through 11-*n*), adders (12-1 through 12-*n*), a tap coefficient register module 13, a selector 15, a quality measurement module 17, and a selector controller 19.

Each of the multipliers 10 (10-0 through 10-*n*) multiplies two input values so as to output the result of multiplication. One input of each of the multipliers 10 is connected to the input terminal L1. The other input of the multiplier 10 is connected to the tap coefficient register module 13. Corresponding tap coefficients (*C0* through *Cn*) are respectively input to the multipliers 10. Then, the multipliers 10 multiply the input values to the input terminal L1 and the input values of the tap coefficients so as to output the results of multiplication to the delayers 11 (11-0 to 11-*n*), respectively.

Each of the delayers 11 (11-0 through 11-*n*) outputs an input value after delaying the transmission of the input value by one symbol time. For example, each of the delayers 11 is composed of a flip-flop operating in synchronization with a clock having one symbol time interval as a cycle.

An output of the multiplier 10-0 is connected to an input of the delayer 11-0. The delayer 11-0 delays the input value by one symbol time so as to output the input value to the selector 15 and the adders 12-1 through 12-*n*.

The adders 12-1 through 12-n are respectively connected to inputs of the delayers 11-1 through 11-*n*, which delay the input values by one symbol time so as to output the delayed input values to the selector 15 and the adders 12-2 through 12-*n*.

Each of the adders 12 (12-1 through 12-*n*) adds two input values so as to output the result of addition. The adders 12-1 through 12-(*n*-1) add the input values output from the delayers 11-0 through 11-*n* and the multipliers 10-1 through 10-*n* so as to output the results of addition to the delayers 11-1 through 11-*n*, respectively.

More specifically, the filter 3 is configured as follows.

The multiplier 10-*k* (1 *≤ k ≤ N*) multiplies the input signal from the input terminal L1 and a tap coefficient Ck. The delayer 11-1 delays a value output from the delayer 10-1 by one symbol time. The delayer 11-*h* (2 ≤ *h* ≤ *N*) delays a value output from the adder 12-*h* by one symbol time. The adder 12-*j* (1 ≤ *j* ≤ *N*) adds the value output from the delayer 11-(*j*-1) and the value output from the multiplier 10-*j*. The values output from all the delayers 11-*h* are input to the selector 15.

The tap coefficient register module 13 calculates an optimal value for the tap coefficient to set the tap coefficient so as to output the set tap coefficient to the multiplier 10.

The tap coefficients (*C0* through *Cn*) set by the tap coefficient register module 13 are set by using an optimal value or a suboptimal value calculating method such as the "peak distortion criterion" or the "mean square error criterion" as described in the above-cited "Digital Communications", Chapter 10, pages 698 to 704.

The signal from the input terminal L1 and the signals from the outputs of the respective delayers 11 (11-0 through 11-*n*) are input to the selector 15. The selector 15 selectively outputs one of the input values. The selector 15 selects the input value designated by the selector controller 19 so as to output the selected input value to the output terminal L2.

The quality measurement module 17 monitors the output value from the selector 15. The quality measurement module 17 measures a quality of the output value and notifies the selector controller 19 of the result of measurement. For example, the quality measurement module 17 measures a bit error ratio (BER) of the signal output from the output terminal L2. The quality measurement module 17 is not required to be provided for the filter 3. It suffices that the quality measurement module 17 can measure the quality of the output signal from the filter 3. For example, the quality measurement module 17 may be provided for the transmitter 1A or the receiver 2A so as to measure the quality of the signal in the transmission channel or of the output signal from the filter 3.

The selector controller 19 directs the selection of the signal to be output from the selector 15. The selector controller 19 directs the selector 15 to output the signal so that the result of the quality measured by the quality measurement module 17 satisfies a quality required for the filter 3.

More specifically, first, the selector controller 19 selects any one of the signal at the input terminal L1 or the output from the delayer 11-0 as an output value from the selector 15. Then, if the output signal does not satisfies the required quality, the selector controller 19 selects the output from the delayer 11-1 situated downstream of the delayer 11-0 as an output value of the selector 15. The increase of *n* for the delayer 11-*n* means the increase of the number of taps. Generally, when the number of taps increases, a quality improvement rate can also be increased. Therefore, by setting the number of taps which is the most suitable for the required quality of the transmission channel 4A, a signal can be transmitted with a suitable quality.

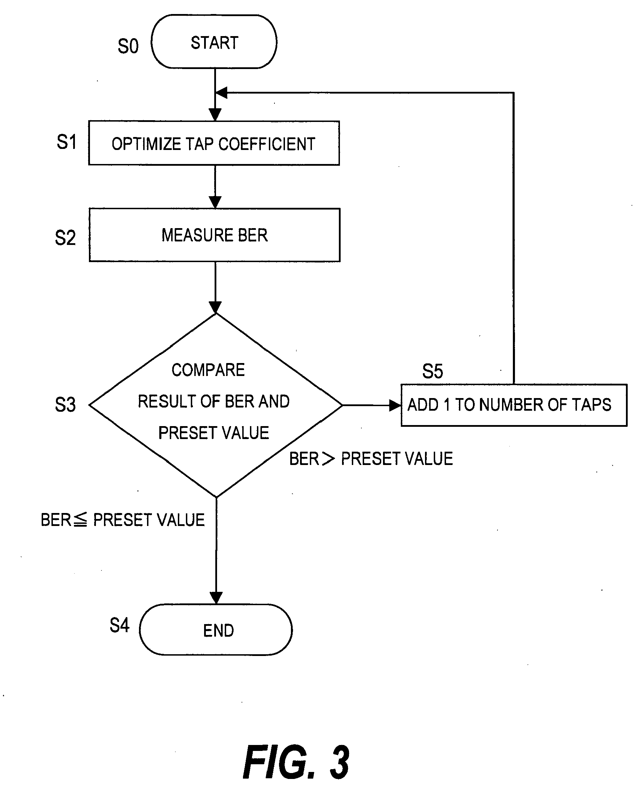

FIG. 3 is a flowchart of control of the number of taps by the selector controller 19.

At the start of transmission of a signal by the filter 3, a processing of the selector controller 19 is also started (S0). The number of taps at this time is an initial value (for example, 0).

First, the tap coefficient register module 13 executes a tap coefficient optimization process with a current number of taps (S1). This process determines the number of taps, which is optimal for transmitting a signal in a bandwidth in conformity with a frequency characteristic of the transmission channel 4A.

Next, for an output signal from the filter 3 by using the number of taps determined in S1, a quality (for example, a BER) is obtained by the quality measurement module (S2).

Then, the preset value of the required quality of the filter 3 and the obtained result of quality measurement are compared with each other (S3). As a result of comparison, when the result of quality measurement satisfies the required quality, the process proceeds to S4 to terminate the processing of this flowchart.

On the other hand, as a result of comparison in S3, when the result of quality measurement does not satisfy the required quality, the selector controller 19 controls the selector 15 to increase the number of taps by one (or more) (S5). After the termination of the process, the process proceeds to S1 so as to repeatedly execute the processes in S1 through S3. At the time when the number of taps satisfying the required quality is determined, the process is terminated.

By the process of this flowchart, a minimum number of taps satisfying the required quality is set.

As described above, the transversal filter according to this embodiment of this invention sets a small number as the number of taps when the required quality of the transmission channel is low. In this manner, the number of delayers 11, through which data passes, is minimized so as to minimize a processing delay. As a result, it becomes possible to enhance the signal so as to satisfy the required quality of the transmission channel, and to minimize a processing delay of the filter 3.

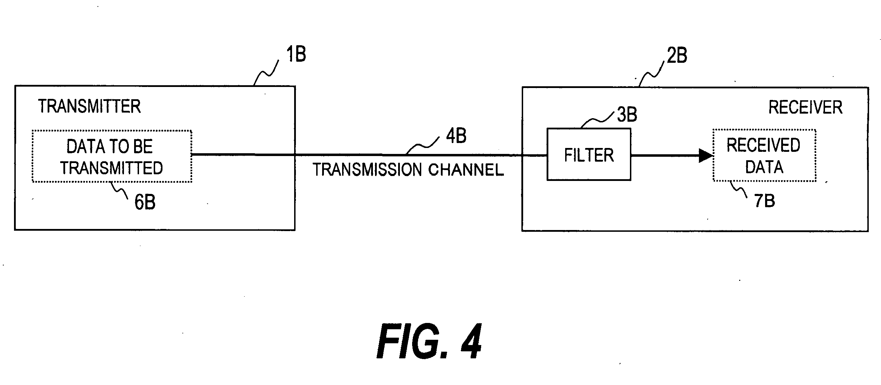

FIG. 4 is an explanatory diagram of another example of the signal transmission system using the transversal filter according to this invention.

A transmitter 1B and a receiver 2B are connected to each other through a transmission channel 4B. The transmitter 1B transmits transmitted data 6B to the receiver 2B through the transmission channel 4B. The receiver 2B receives the transmitted data as received data 7B.

The receiver 2B includes a filter 3B. The filter 3B is composed of the transversal filter described above with reference to FIG. 2.

After enhancing the signal received through the transmission channel so as to obtain an optimal signal in the receiver 2B, the filter 3B converts the signal into the received data 7B.

In this manner, the transmitter 1B may transmit the transmitted data without compensation in conformity with the frequency response characteristic *C(f)* of the transmission channel. Instead, the signal attenuated through the transmission channel may be enhanced on the receiver side to satisfy the required quality of the transmission channel.

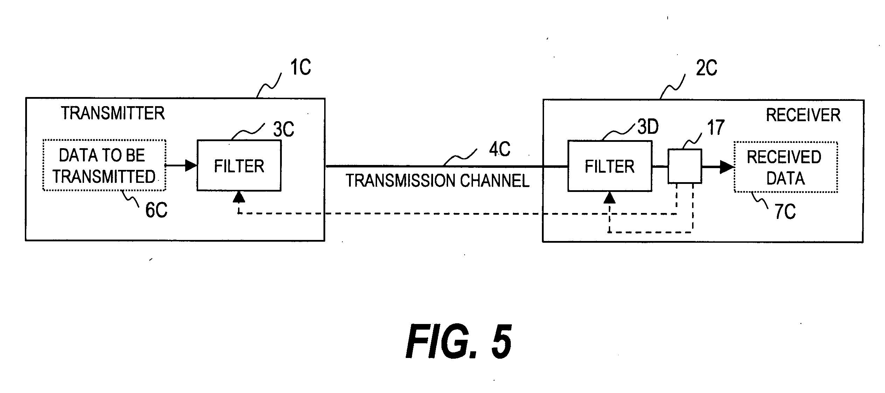

FIG. 5 is an explanatory diagram of further another example of the signal transmission system using the transversal filters according to this invention.

A transmitter 1C and a receiver 2C are connected to each other through a transmission channel 4C. The transmitter 1C transmits transmitted data 6C to the receiver 2C through the transmission channel 4C. The receiver 2C receives the data as received data 7C. The transmitter 1C includes a filter 3C, whereas the receiver 2C includes a filter 3D. Each of the filters 3C and 3D is composed of the transversal filter described above with reference to FIG. 2.

The quality measurement module 17 of the filters 3C and 3D is provided in the receiver 2C. The quality measurement module 17 measures the quality of a signal in the transmission channel 4C so as to transmit information regarding the measured quality to the filter 3C of the transmitter 1C and the filter 3D of the receiver 2C. The information regarding the quality may be transmitted to the filter 3C of the transmitter 1C through the transmission channel 4C or through other communication channels.

After enhancing the transmitted data 6C so as to obtain an optimal signal at the frequency response characteristic *C(f)* of the transmission channel and at the time when the receiver 2C receives the signal, the filter 3C transmits the obtained signal to the transmission channel. On the other hand, the filter 3D enhances the signal received through the transmission channel so as to obtain an optimal signal in the receiver 2C as the received data 7C.

In this manner, the transmitter side transmits a signal to be transmitted to the transmission channel after enhancing the signal so as to be optimal at the frequency response characteristic *C(f)* and at the time when the receiver 2C receives the signal. On the other hand, the receiver side may enhance a signal attenuated through the transmission channel so as to satisfy the required quality of the transmission channel.

In this manner, the filter on the transmitter side and the filter on the receiver side may be used solely or in combination. In any case, the principle of this invention remains unchanged.

This invention concerns a transmission channel characteristic improving filter provided for a communication interface and is available in all the devices including a communication interface, such as a network device (a router, a switch, a transmission device, a media converter, a repeater, a gateway, or the like), a personal computer, a server, a large-scale computer, a disk array system, or a network attached storage (NAS).

While the present invention has been described in detail and pictorially in the accompanying drawings, the present invention is not limited to such detail but covers various obvious modifications and equivalent arrangements, which fall within the purview of the appended claims.

## Claims

1. A transversal filter, in which delayers and multipliers are connected in series, comprising:
a first multiplier for multiplying a first tap coefficient set by a tap coefficient register module and an input signal to output a result of multiplication;
a first delayer for delaying the value output from the first multiplier by a predetermined time to output the delayed value;
a second multiplier for multiplying a second tap coefficient set by the tap coefficient register module and an input signal to output a result of multiplication;
a first adder for adding the value output from the delayer situated upstream to the value output from the second multiplier to output a result of addition;
a second delayer for delaying the value output from the first adder by a predetermined time to output the delayed value; and
a selector for selecting one of the input signal, the value output from the first delayer, and the value output from the second delayer to output the selected one.

2. A transversal filter comprising:
*N* multipliers;
*N* delayers;
*N*-1 adders;
a tap coefficient register module; and
a selector, wherein:
a first delayer delays a value output from a first multiplier by a predetermined time;
a *k*-th (1 ≤ *k* ≤ *N*) multiplier multiplies a tap coefficient designated by the tap coefficient register module and an input signal;
a *j*-th (1 ≤ *j* ≤ *N*-1) adder adds a value output from the (*j*-1)-th delayer to a value output from the *j*-th multiplier;
a *h*-th (2 ≤ *h* ≤ *N*) delayer delays a value output from the (*h*-1)-th adder by a predetermined time; and
the selector selects one of the input signal and the value output from the *N*-th delayer to output the selected one.

3. The transversal filter according to Claim 1, further comprising:
a selector control module for designating a value to be selected by the selector; and
a quality measurement module for measuring a quality of an output signal from the selector,
wherein the selector control module designates the value to be selected by the selector based on a result of comparison between the quality of the signal measured by the quality measurement module and a quality required for the output value.

4. The transversal filter according to Claim 1, further comprising:
a selector control module for designating a value to be selected by the selector; and
a quality measurement module for measuring a quality of an output signal from the selector, wherein:
the tap coefficient register module sets a tap coefficient corresponding to the multiplier;
the quality measurement module measures the quality of the output signal from the selector; and
the selector control module compares the quality of the signal measured by the quality measurement module and a quality required for the output signal and designates the value to be selected by the selector to add one to the number of taps when the measured quality of the signal does not satisfy the quality required for the output signal as a result of the comparison.

5. A transmitter for transmitting data to a receiver through a transmission channel, comprising a filter for converting the data into a signal suitable for a frequency characteristic of the transmission channel, the filter having delayers and multipliers connected in series,
wherein the filter comprises:
a first multiplier for multiplying a first tap coefficient set by a tap coefficient register module and an input signal to output a result of multiplication;
a first delayer for delaying the value output from the first multiplier by a predetermined time to output the delayed value;
a second multiplier for multiplying a second tap coefficient set by the tap coefficient register module and an input signal to output a result of multiplication;
a first adder for adding the value output from the delayer situated upstream to the value output from the second multiplier to output a result of addition;
a second delayer for delaying the value output from the first adder by a predetermined time to output the delayed value; and
a selector for selecting one of the input signal, the value output from the first delayer, and the value output from the second delayer to output the selected one.

6. A transmitter for transmitting data to a receiver through a transmission channel, comprising a filter for converting the data into a signal suitable for a frequency characteristic of the transmission channel,
wherein:
the filter comprises
*N* multipliers, *N* delayers, *N*-1 adders, a tap coefficient register module, and a selector;
a first delayer delays a value output from a first multiplier by a predetermined time;
a *k*-th (1 ≤ *k* ≤ *N*) multiplier multiplies a tap coefficient designated by the tap coefficient register module and an input signal;
a *j*-th (1 *≤ j ≤ N-*1) adder adds a value output from the (*j*-1)-th delayer to a value output from the j-th multiplier;
a *h*-th (2 ≤ *h* ≤ *N*) delayer delays a value output from the (*h*-1)-th adder by a predetermined time; and
the selector selects one of the input signal and the value output from the N-th delayer to output the selected one.

7. The transmitter for transmitting data according to Claim 5,
wherein:
the filter comprises a selector control module for designating a value to be selected by the selector, and a quality measurement module for measuring a quality of an output signal from the selector; and
the selector control module designates the value to be selected by the selector based on a result of comparison between the quality of the signal measured by the quality measurement module and a quality required for the output value.

8. The transmitter for transmitting data according to Claim 5,
wherein:
the filter comprises a selector control module for designating a value to be selected by the selector, and a quality measurement module for measuring a quality of an output signal from the selector;
the tap coefficient register module sets a tap coefficient corresponding to the multiplier;
the quality measurement module measures the quality of the output signal from the selector; and
the selector control module compares the quality of the signal measured by the quality measurement module and a quality required for the output value and designates the value to be selected by the selector to add one to the number of taps when the measured signal quality does not satisfy the quality required for the output signal as a result of the comparison.

9. The transmitter for transmitting data according to Claim 7,
wherein the quality measurement module is included in the receiver.

10. A receiver for receiving data from a transmitter through a transmission channel, comprising a filter for converting the received data into a signal suitable for a frequency characteristic of the transmission channel, the filter having delayers and multipliers connected in series,
wherein the filter comprises:
a first multiplier for multiplying a first tap coefficient set by a tap coefficient register module and an input signal to output a result of multiplication;
a first delayer for delaying the value output from the first multiplier by a predetermined time to output the delayed value;
a second multiplier for multiplying a second tap coefficient set by the tap coefficient register module and an input signal to output a result of multiplication;
a first adder for adding the value output from the delayer situated upstream to the value output from the second multiplier to output a result of addition;
a second delayer for delaying the value output from the first adder by a predetermined time to output the delayed value; and
a selector for selecting one of the input signal, the value output from the first delayer, and the value output from the second delayer to output the selected one.
